# EUROPEAN PATENT APPLICATION

(11) **EP 4 379 775 A1**
(43) Date of publication of application: **05.06.2024**
(21) Application number: 22849357.3
(22) Date of filing: 21.07.2022
(51) Int. Cl.: H01L 21/205, C23C 16/34

(54) **METHOD FOR PRODUCING GROUP III-NITRIDE SEMICONDUCTOR**

(30) Priority: 30.07.2021 JP 2021125398
(71) Applicant: SCREEN Holdings Co., Ltd., Kyoto-shi, Kyoto 602-8585 (JP); National University Corporation Tokai National Higher Education and Research System, Nagoya-shi, Aichi 464-8601 (JP)
(72) Inventor: INABA Masaki, Kyoto-shi, Kyoto 602-8585 (JP); MIYAGI Masahiro, Kyoto-shi, Kyoto 602-8585 (JP); HORI Masaru, Nagoya-shi, Aichi 464-8601 (JP); ODA Osamu, Nagoya-shi, Aichi 464-8601 (JP); KODAMA Kazuki, Nagoya-shi, Aichi 464-8601 (JP)
(74) Representative: Kilian Kilian & Partner mbB
(86) International application number: PCT/JP2022/028301
(87) International publication number: WO 2023/008295

(57) **Abstract**

A method of manufacturing a group III-nitride semiconductor includes a loading step (S 1), a pressure reduction step (S2), a heating step (S3), a first film forming step (S5), and a second film forming step (S6). In the loading step (S1), a substrate is loaded into a chamber. In the pressure reduction step (S2), a pressure in the chamber is reduced. In the heating step (S3), the substrate is heated. In the first film forming step (S5), an organic metal gas containing a group III element is supplied to the substrate in the chamber, and a first gas containing hydrogen gas and nitrogen gas is excited into plasma and supplied to the substrate in the chamber. In the second film forming step (S6), an organic metal gas containing the group III element is supplied to the substrate in the chamber, and a second gas not containing hydrogen gas and containing nitrogen gas is excited into plasma and supplied to the substrate in the chamber.

## Description

### TECHNICAL FIELD

The present application relates to a method of manufacturing a group III-nitride semiconductor.

### BACKGROUND ART

Conventionally, the metal organic chemical vapor deposition utilizing plasma has been proposed (for example, Patent Document 1). In the manufacturing apparatus described in Patent Document 1, organic metal gas of a group III element is supplied into a chamber while a mixture gas of nitrogen (N₂) gas and hydrogen (H₂) gas is plasma-processed in the chamber. According to this, a group III nitride semiconductor film can be formed on a substrate at a relatively low temperature.

### PRIOR ART DOCUMENTS

### PATENT DOCUMENT(S)

[Patent Document 1] Patent No. 6516482

### SUMMARY

### PROBLEM TO BE SOLVED BY THE INVENTION

The technique described in Patent Document 1 has a problem in that, although a group III-nitride semiconductor film can be formed at low temperatures, more carbon is taken into the semiconductor film as the temperature lowers. As the carbon content in the semiconductor film increases, bulk mobility of the semiconductor film decreases, resulting in a decrease in film quality.

In addition to bulk mobility, surface morphology is also a characteristic for evaluating group III-nitride semiconductor films. It is desirable to have good surface morphology.

Therefore, an object of the present application is to provide a technique that can produce a group III-nitride semiconductor with a low carbon content and good surface morphology.

### MEANS TO SOLVE THE PROBLEM

A first aspect of a method of manufacturing a group III-nitride semiconductor being a method of manufacturing a group III-nitride semiconductor that includes a loading step in which a substrate is loaded into a chamber, a pressure reduction step in which a suction unit reduces a pressure in the chamber, a heating step in which a heater provided in the chamber heats the substrate, a first film forming step in which a first gas supply unit supplies an organic metal gas containing a group III element to the substrate in the chamber, a second gas supply unit supplies a first gas containing hydrogen gas and nitrogen gas to a plasma generation unit, and the plasma generation unit excites the first gas into plasma and supplies the first gas to the substrate in the chamber, and a second film forming step in which the first gas supply unit supplies an organic metal gas containing the group III element to the substrate in the chamber, the second gas supply unit supplies a second gas not containing hydrogen and containing nitrogen gas to the plasma generation unit, and the plasma generation unit excites the second gas into plasma and supplies the second gas to the substrate in the chamber.

A second aspect of the method of manufacturing the group III-nitride semiconductor being the method of manufacturing the group III-nitride semiconductor according to the first aspect, that further includes a hydrogen gas removal step in which the hydrogen gas is exhausted from the chamber between the first film forming step and the second film forming step.

A third aspect of the method of manufacturing the group III-nitride semiconductor is the method of manufacturing the group III-nitride semiconductor according to the second aspect, in which the hydrogen gas removal step is performed until a partial pressure of hydrogen gas in the chamber becomes 1×10-8 Pa or less.

A second aspect of the method of manufacturing the group III-nitride semiconductor is the method of manufacturing a group III-nitride semiconductor according to the first aspect, in which the second film forming step is performed consecutively to the first film forming step.

A fourth aspect of the method of manufacturing the group III-nitride semiconductor is the method of manufacturing the group III-nitride semiconductor according to any one of the first to fourth aspects, in which in the second film forming step, after a predetermined period has elapsed since closing a valve of the first gas supply unit for switching between supply and stop of the organic metal gas, supply of the second gas by the second gas supply unit and operation of the plasma generation unit are stopped to end the second film forming step.

A sixth aspect of the method of manufacturing the group III-nitride semiconductor is the method of manufacturing the group III-nitride semiconductor according to any one of the first to fifth aspects, in which in the heating step, heating is performed to bring a temperature of the substrate to 600°C or more and 1000°C or less.

A seventh aspect of the method of manufacturing the group III-nitride semiconductor is the method of manufacturing the group III-nitride semiconductor according to any one of the first to sixth aspects, in which the organic metal gas includes trimethyl gallium, triethyl gallium, or tris dimethylamide gallium.

### EFFECTS OF THE INVENTION

According to the first to seventh aspects of the method of manufacturing the group III-nitride semiconductor, in the first film forming step, the first gas to be turned into plasma contains hydrogen gas. Accordingly, the group III-nitride semiconductor can be crystal-grown with high film thickness uniformity on the heterogeneous material the substrate.

On the other hand, in the second film forming step, the second gas to be turned into plasma does not contain hydrogen. Accordingly, in the second film forming step, the group III-nitride semiconductor having a low carbon content can be formed.

Further, in the second film forming step, the homogeneous group III-nitride semiconductor is crystal-grown on the flat group III-nitride semiconductor formed in the first film forming step. Thus, the flat group III-nitride semiconductor can be formed in the second film forming step as well.

As described above, the group III-nitride semiconductor having a low carbon content and good surface morphology can be formed.

According to the second and third aspects of the method of manufacturing the group III-nitride semiconductor, the second film forming step can be performed in a state where the amount of hydrogen gas in the chamber is small. Thus, the carbon content in the group III-nitride semiconductor film formed in the second film forming step can be further reduced.

According to the fourth aspect of the method of manufacturing the group III-nitride semiconductor, the group III-nitride semiconductor can be formed with high throughput.

According to the fifth aspect of the method of manufacturing the group III-nitride semiconductor, the pressure inside the chamber is low; therefore, the organic metal gas is supplied into the chamber even after the valve is closed. According to the fifth aspect, the plasma generation unit generates nitrogen radicals until the predetermined period has elapsed, so that the organic metal gas reacts with the nitrogen radicals. Therefore, the group III-nitride semiconductor is crystal-grown during the predetermined period as well.

For comparison, a case will be described in which the closing of the valve and the operation stop of the plasma generation unit are performed simultaneously. In this case, the organic metal gas reacts with the group III-nitride semiconductor without reaction with nitrogen. According to this, the surface condition of the group III-nitride semiconductor film potentially deteriorates.

In contrast, in the fifth aspect, the organic metal gas reacts with nitrogen radicals during the predetermined period as well, and deterioration of the surface condition can be suppressed or avoided.

### BRIEF DESCRIPTION OF DRAWINGS

[FIG. 1] A diagram schematically illustrating an example of a configuration of a manufacturing apparatus for a group III-nitride semiconductor.
[FIG. 2] A block diagram illustrating an example of an internal configuration of a control unit.
[FIG. 3] A flowchart illustrating an example of a method of manufacturing a group III-nitride semiconductor according to Embodiment 1.
[FIG. 4] A graph illustrating an example of the distribution of carbon concentration in a semiconductor film according to Embodiment 1.
[FIG. 5] A diagram illustrating an image of the front surface of the group III-nitride semiconductor film obtained by a scanning electron microscope.
[FIG. 6] A diagram illustrating an image of the front surface of a group III-nitride semiconductor film according to a comparative example obtained by a scanning electron microscope.
[FIG. 7] A flowchart illustrating an example of a method of manufacturing a group III-nitride semiconductor according to Embodiment 2.
[FIG. 8] A graph illustrating an example of a temporal change in the partial pressure of hydrogen gas.
[FIG. 9] A graph illustrating an example of the distribution of carbon concentration in a semiconductor film according to Embodiment 2.
[FIG. 10] A flowchart illustrating an example of a method of manufacturing a group III-nitride semiconductor according to Embodiment 3.

### DESCRIPTION OF EMBODIMENT(S)

Embodiments will be described below with reference to the accompanying drawings. Note that the components described in Embodiments are merely examples, and the scope of the present disclosure is not intended to be limited thereto. In the drawings, dimensions or numbers of parts may be exaggerated or simplified as necessary for easy understanding.

In the use of terms that express the relative or absolute positional relationship (for example, "in one direction" "along one direction", "parallel", "orthogonal", "center", "concentric", "coaxial", etc.), the terms express not only a state where the precise positional relationship is described, but also a state of being displaced relative to an angle or distance to the extent that tolerance or similar functionality is obtained, unless otherwise specified. In the use of descriptions representing equivalency such as "same", "equal", and "homogeneous", the descriptions include the case of being a quantitatively exact equal state and the case where there is a difference within the tolerance or the range where the same function can be obtained, unless otherwise specified. Further, unless otherwise specified, in the use of descriptions representing shapes (for example, "quadrangle", "cylinder", or the like), the descriptions express not only geometrically precisely the shapes but also express shapes insofar as similar effects can be achieved, and the shapes may include, for example, a roughened portion, a chamfered portion, and the like. In the use of an expression that an X "is provided with", "equips", "comprises", "includes", or "has", the expression is not an exclusive expression that excludes the existence of other components. Further, in the use of an expression "at least one of A, B, and C" includes "only A", "only B", "only C", "any two of A, B, and C", and "all of A, B, and C".

### <Embodiment 1>

### <Overview of Manufacturing Apparatus>

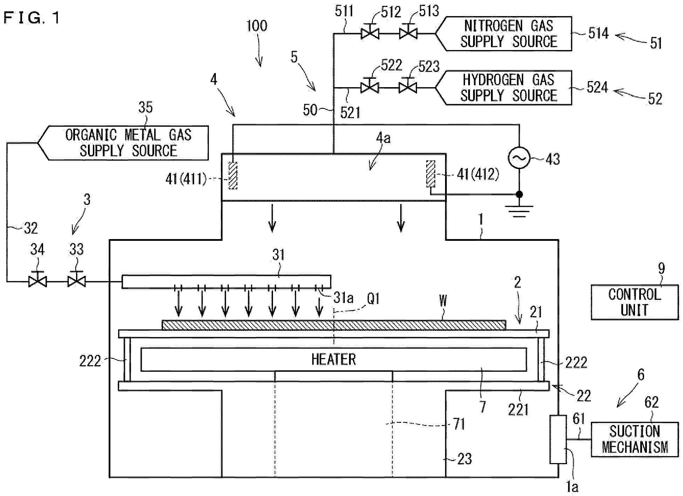

FIG. 1 is a diagram schematically illustrating an example of a configuration of a manufacturing apparatus 100 of a group III-nitride semiconductor. The manufacturing apparatus 100 is a film forming apparatus that forms a group III-nitride semiconductor film on the main surface of a substrate W by the metal organic chemical vapor deposition utilizing plasma. The group III-nitride semiconductor is used, for example, in lateral transistors.

The substrate W is, for example, a substrate of sapphire, silicon carbide, silicon, or the like. The substrate W has, for example, a disk shape. The group III-nitride semiconductor film is crystal-grown on the main surface of the substrate W, from this, the substrate W can also be referred to as a growth substrate. Note that the material and shape of the substrate W are not limited thereto, and may be changed as appropriate.

The manufacturing apparatus 100 includes a chamber 1, a substrate holding unit 2, a first gas supply unit 3, a plasma generation unit 4, a second gas supply unit 5, a suction unit 6, a heater 7, and a control unit 9. Hereinafter, each configuration will be outlined, and then a specific example will be described in detail.

The chamber 1 has a box-like hollow shape. The internal space of the chamber 1 corresponds to a processing space in which the substrate W is subjected to a film formation process. The chamber 1 may also be referred to as a vacuum chamber.

The substrate holding unit 2 is provided within the chamber 1. The substrate holding unit 2 holds the substrate W in a horizontal orientation. The horizontal orientation here refers to an orientation in which the thickness direction of the substrate W extending along the vertical direction.

The suction unit 6 sucks the gas inside the chamber 1 to reduce the pressure inside the chamber 1. The suction unit 6 regulates the pressure within the chamber 1 to within a predetermined reduced pressure range suitable for the film forming process.

The heater 7 is provided within the chamber 1 and heats the substrate W. Specifically, the heater 7 heats the substrate W so that the temperature of the substrate W falls within a temperature range suitable for the film forming process.

The first gas supply unit 3 supplies the organic metal gas containing a group III element to the substrate W in the chamber 1. Group III elements are also referred to as group-13 elements, such as gallium. In this case, trimethyl gallium (TMGa), triethyl gallium (TEGa), or tris dimethylamide gallium (TDMAGa) is adoptable as the organic metal gas.

The second gas supply unit 5 supplies a gas containing group V elements to the plasma generation unit 4. Group V elements are also referred to as group-15 elements, with nitrogen being one of them. The second gas supply unit 5 supplies a first gas containing nitrogen gas and hydrogen gas to the plasma generation unit 4, or supplies a second gas not containing hydrogen but containing nitrogen gas to the plasma generation unit 4. That is, the second gas supply unit 5 selectively supplies a hydrogen gas to the plasma generation unit 4. This switching of the gases will be described in detail later. Hereinafter, the gas that the second gas supply unit 5 supplies to the plasma generation unit 4 will also be referred to as a group V gas.

The plasma generation unit 4 excites the group V gas for plasma. In other words, the plasma generation unit 4 turns the V group gas into plasma. This generates active species such as highly reactive ions or neutral radicals. When the V group gas contains hydrogen gas and nitrogen gas, hydrogen radicals and nitrogen radicals are generated as active species. When the V group gas does not contain hydrogen and contains nitrogen gas, hydrogen radicals are not generated and nitrogen radicals are generated. In the example of FIG. 1, the plasma generation unit 4 has a plasma chamber 4a, and the V group gas is turned into plasma in the plasma chamber 4a, and the above-mentioned active species are generated depending on the type of the V group gas. The active species flow out of the plasma chamber 4a and flow toward the substrate W within the chamber 1. As a result, active species are supplied to the substrate W within the chamber 1.

The control unit 9 controls the entire manufacturing apparatus 100 in an integrated manner. For example, the control unit 9 controls the substrate holding unit 2, the first gas supply unit 3, the plasma generation unit 4, the second gas supply unit 5, the suction unit 6, and the heater 7.

Next, a specific example of each configuration will be described in detail.

### <Substrate Holding Unit>

The substrate holding unit 2 holds the substrate W in a horizontal orientation. In the example of FIG. 1, the substrate holding unit 2 includes a susceptor 21 and a susceptor holding unit 22. The susceptor 21 is a base on which the substrate W is placed, and has, for example, a flat plate shape. The susceptor 21 is provided in a horizontal orientation, and the substrate W is placed on the upper surface of the susceptor 21 in a horizontal orientation. The upper surface of the substrate W placed on the susceptor 21 is exposed inside the chamber 1.

The susceptor holding unit 22 is provided within the chamber 1 and holds the susceptor 21. In the example of FIG. 1, the susceptor holding unit 22 includes a holding base 221 and a holding protrusion 222. The holding base 221 is provided vertically below the susceptor 21, and faces the susceptor 21 with an interval in the vertical direction. The holding base 221 has, for example, a horizontal upper surface, and on this upper surface, the holding protrusion 222 is erected. For example, a plurality of holding protrusions 222 are provided, and are arranged in line along the peripheral edge of the lower surface of the susceptor 21. The tip of the holding protrusion 222 is in contact with the susceptor 21 and supports or holds the susceptor 21.

In the example of FIG. 1, the substrate holding unit 2 further includes a rotation mechanism 23. The rotation mechanism 23 rotates the susceptor holding unit 22 around the rotation axis Q1. The rotation axis Q1 is an axis passing through the center of the substrate W and extending in the vertical direction. The rotation mechanism 23 includes, for example, a shaft and a motor. The upper end of the shaft is connected to the lower surface of the holding base 221. The shaft extends along the rotational axis Q1 and is rotatably supported by the chamber 1 about the rotational axis Q1. The motor rotates the shaft around the axis of rotation Q1. Accordingly, the susceptor holding unit 22, the susceptor 21, and the substrate W rotate together around the rotation axis Q1.

### <Heater>

The heater 7 heats the substrate W held by the substrate holding unit 2 in the chamber 1. In the example of FIG. 1, the heater 7 is provided vertically below the susceptor 21, and faces the susceptor 21 in the vertical direction. In the example of FIG. 1, the heater 7 is provided between the susceptor 21 and the holding base 221, and it is positioned on the inner side in the radial direction relative to the holding protrusion 222. The heater 7 may also be, for example, an electric resistance heater that includes a heating wire, or an optical heater that includes a light source that irradiates heating light.

Here, the heater 7 is provided to not rotate around the rotation axis Q1. In other words, the heater 7 is non-rotating. For example, the shaft of the rotation mechanism 23 is a hollow shaft, and the heater 7 is fixed to the chamber 1 with a fixing member 71 that extends through the hollow part.

### <Suction Unit>

The suction unit 6 sucks the gas inside the chamber 1. In the example of FIG. 1, the suction unit 6 includes a suction tube 61 and a suction mechanism 62. The upstream end of the suction tube 61 is connected to an exhaust port 1a of the chamber 1. In the example of FIG. 1, the exhaust port 1a is formed vertically below the substrate W held by the substrate holding unit 2, and is formed in the side wall of the chamber 1, for example. The suction mechanism 62 is, for example, a pump (more specifically, a vacuum pump), and is connected to the suction tube 61. The suction mechanism 62 is controlled by the control unit 9 to suck the gas in the chamber 1 through the suction tube 61.

### <Second Gas Supply Unit>

The second gas supply unit 5 supplies the group V gas to the plasma generation unit 4 (more specifically, a plasma chamber 4a). As illustrated in FIG. 1, the second gas supply unit 5 includes a nitrogen gas supply unit 51 and a hydrogen gas supply unit 52. The nitrogen gas supply unit 51 supplies nitrogen gas to the plasma generation unit 4, and the hydrogen gas supply unit 52 supplies hydrogen gas to the plasma generation unit 4.

In the example of FIG. 1, the nitrogen gas supply unit 51 includes a supply tube 511, a valve 512, and a flow rate regulation unit 513. In the example of FIG. 1, the downstream end of the supply tube 511 is connected to the upstream end of a common tube 50, and the upstream end of the supply tube 511 is connected to the nitrogen gas supply source 514. The nitrogen gas supply source 514 supplies nitrogen gas to the upstream end of the supply tube 511. The downstream end of the common tube 50 is connected to the plasma generation unit 4.

The valve 512 is installed in the supply tube 511. The valve 512 is controlled by control unit 9, and by opening the valve 512, nitrogen gas is supplied from the nitrogen gas supply source 514 to the plasma generation unit 4 through the supply tube 511 and the common tube 50. By closing the valve 512, the supply of nitrogen gas stops.

The flow rate regulation unit 513 is installed in the supply tube 511. The flow rate regulation unit 513 is controlled by the control unit 9 and regulates the flow rate of nitrogen gas flowing through the supply tube 511. The flow rate regulation unit 513 is, for example, a mass flow controller.

In the example of FIG. 1, the hydrogen gas supply unit 52 includes a supply tube 521, a valve 522, and a flow rate regulation unit 523. In the example of FIG. 1, the downstream end of the supply tube 521 is connected to the upstream end of the common tube 50, and the upstream end of the supply tube 521 is connected to the hydrogen gas supply source 524. A hydrogen gas supply source 524 supplies hydrogen gas to the upstream end of the supply tube 521.

The valve 522 is installed the in supply tube 521. The valve 522 is controlled by control unit 9, and by opening the valve 522, hydrogen gas is supplied from the hydrogen gas supply source 524 to the plasma generation unit 4 through the supply tube 521 and the common tube 50. By closing the valve 522, the supply of hydrogen gas stops.

The flow rate regulation unit 523 is installed in the supply tube 521. The flow rate regulation unit 523 is controlled by the control unit 9 and regulates the flow rate of hydrogen gas flowing through the supply tube 521. The flow rate regulation unit 523 is, for example, a mass flow controller.

By opening the valve 512 and the valve 522, the second gas supply unit 5 can supply the first gas containing nitrogen gas and hydrogen gas to the plasma generation unit 4 as a group V gas. By opening the valve 512 and closing the valve 522, the second gas supply unit 5 can supply the second gas not containing hydrogen but containing nitrogen gas to the plasma generation unit 4 as a group V gas. In this manner, the second gas supply unit 5 can switch between the first gas and the second gas as a group V gas.

### <Plasma Generation Unit>

The plasma generation unit 4 turns the V group gas supplied from the second gas supply unit 5 into plasma. In the example of FIG. 1, the plasma generation unit 4 is provided on the ceiling of the chamber 1. The plasma generation unit 4 includes a conductive member 41 and a plasma power source 43. The conductive member 41 is provided within the plasma chamber 4a, for example, and the plasma power source 43 is electrically connected to the conductive member 41. The plasma power source 43 is controlled by the control unit 9 and applies a plasma voltage (for example, a high frequency voltage) to the conductive member 41. As a result, an electric field (or magnetic field) for generating plasma is formed around the conductive member 41.

In the example of FIG. 1, an electrode 411 and an electrode 412 are illustrated as the conductive member 41. The electrode 411 and the electrode 412 are provided facing each other with an interval in the horizontal direction. The plasma power source 43 is electrically connected to the electrode 411 and the electrode 412, and applies a plasma voltage between the electrode 411 and the electrode 412. The plasma power source 43 outputs, for example, a high frequency voltage between the electrode 411 and the electrode 412. As a result, an electric field for plasma is generated in the space between the electrode 411 and the electrode 412.

In the example of FIG. 1, the downstream end of the common tube 50 of the second gas supply unit 5 is connected to the upper part of the plasma chamber 4a. The group V gas supplied from the common tube 50 flows vertically downward between the electrode 411 and the electrode 412 in the plasma chamber 4a; therefore, an electric field for plasma is applied to the group V gas between the electrodes 411 and 412. Consequently, at least a portion of the group V gas is turned into plasma, and active species are generated. The excited gas containing the active species flows out of the plasma chamber 4a vertically downward and flows toward the substrate W.

In the example of FIG. 1, although the plasma generation unit 4 generates plasma using a so-called capacitive coupling method, an inductive coupling method may also be adopted to generate plasma.

### <First Gas Supply Unit>

The first gas supply unit 3 supplies the organic metal gas into the chamber 1. In the example of FIG. 1, the first gas supply unit 3 includes a discharge nozzle 31, a supply tube 32, a valve 33, and a flow rate regulation unit 34. A discharge nozzle 31 is provided within the chamber 1. In the example of FIG. 1, the discharge nozzle 31 is provided vertically above the substrate holding unit 2, and discharges the organic metal gas toward the substrate W held by the substrate holding unit 2. In the example of FIG. 1, the discharge nozzle 31 has an elongated shape that extends horizontally, and faces the substrate holding unit 2 in the vertical direction. The discharge nozzle 31 extends, for example, along the radial direction of the substrate W in plan view. In other words, the longitudinal direction of the discharge nozzle 31 is along the radial direction of the substrate W. In the example of FIG. 1, the discharge nozzle 31 is provided such that the tip of the discharge nozzle 31 faces the center of the substrate W in the vertical direction.

The discharge nozzle 31 has a discharge port 31a formed therein. In the example of FIG. 1, a plurality of discharge ports 31a are arranged along the longitudinal direction of the discharge nozzle 31 at intervals. The plurality of discharge ports 31a are provided at positions facing the substrate W in the vertical direction, and the organic metal gas is discharged toward the upper surface of the substrate W from each discharge port 31a.

The organic metal gas flows toward the substrate holding unit 2 on the opposite side from the plasma generation unit 4; therefore, the electric field (or magnetic field) of the plasma generation unit 4 is hardly applied to the organic metal gas. In other words, the discharge nozzle 31 is provided at a distance from the plasma generation unit 4 such that the electric field (or magnetic field) of the plasma generation unit 4 is not substantially applied thereto. Therefore, the organic metal gas is not substantially turned into plasma.

The discharge nozzle 31 is connected to an organic metal gas supply source 35 with the supply tube 32 therebetween. That is, the downstream end of the supply tube 32 is connected to the upstream end of the discharge nozzle 31, and the upstream end of the supply tube 32 is connected to the organic metal gas supply source 35. The organic metal gas supply source 35 supplies the organic metal gas to the upstream end of the supply tube 32.

The valve 33 is installed the in supply tube 32 and controlled by the controlled by the control unit 9. By opening the valve 33, the organic metal gas is supplied into the chamber 1 from the organic metal gas supply source 35 through the supply tube 32 and the discharge nozzle 31. By closing the valve 33, the supply of the organic metal gas stops.

The flow rate regulation unit 34 is installed in the supply tube 32. The flow rate regulation unit 34 is controlled by the control unit 9 and regulates the flow rate of the organic metal gas flowing through the supply tube 32. The flow rate regulation unit 34 is, for example, a mass flow controller.

### <Control Unit>

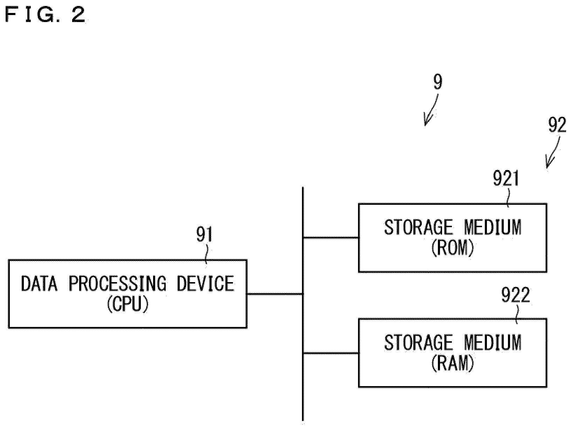

FIG. 2 is a block diagram schematically illustrating an example of a configuration of the control unit. The control unit 9 is an electronic circuit device, and may include, for example, a data processing device 91 and a storage medium 92. The data processing device 91 may be, for example, an arithmetic processing device such as a Central Processor Unit (CPU). The storage medium 92 may include a non-temporary storage medium 921 (for example, a Read Only Memory (ROM) or a hard disk) and a temporary storage medium 922 (for example, a Random Access Memory (RAM)). The non-temporary storage medium 921 may store, for example, a program that specifies the processing to be executed by the control unit 9. When the data processing device 91 executes this program, the control unit 9 can execute the processing specified in the program. It goes without saying that part or all of the processing executed by the control unit 9 may be executed by a hardware circuit such as a logic circuit.

### <Operation of Manufacturing Apparatus of Group III-Nitride Semiconductor>

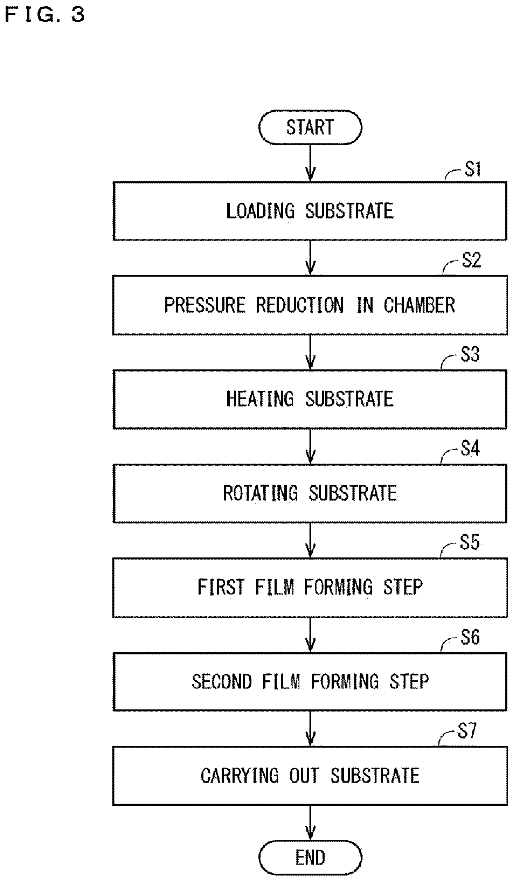

Next, an example of the operation of the Group III-nitride semiconductor manufacturing apparatus 100 will be described. FIG. 3 is a flowchart illustrating an example of the operation of the manufacturing apparatus 100 of the group III-nitride semiconductor. That is, FIG. 3 is a flowchart illustrating an example of a method of manufacturing a group III-nitride semiconductor.

First, the substrate W is transported into the chamber 1 by an unillustrated transport device (Step S 1: loading step).

Next, the suction unit 6 suctions the gas inside the chamber 1 to lower the pressure inside the chamber 1 (Step S2: pressure reduction step). Specifically, the control unit 9 causes the suction mechanism 62 to perform a suction operation. Accordingly, the gas inside the chamber 1 is sucked into the suction mechanism 62 through the suction tube 61, and the pressure inside the chamber 1 is reduced. The suction unit 6 regulates the pressure in the chamber 1 to a predetermined process pressure suitable for film forming process. The predetermined process pressure is, for example, 100 Pa or more and 500 Pa or less. The suction unit 6 regulates the pressure inside the chamber 1 until the film forming process is completed.

Next, the heater 7 heats the substrate W (Step S3: heating step). Specifically, the control unit 9 causes the heater 7 to perform a heating operation. The heater 7 adjusts the temperature of the substrate W so that the temperature of the substrate W falls on a predetermined temperature suitable for the film forming process. The predetermined temperature is, for example, 600°C or more and 1000°C or less. The heater 7 adjusts the temperature of the substrate W until the film forming process is completed.

Next, the substrate holding unit 2 rotates the substrate W around the rotation axis Q1 (Step S4: rotation step). Specifically, the control unit 9 causes the rotation mechanism 23 to rotate the susceptor holding unit 22. Accordingly, the susceptor holding unit 22, the susceptor 21, and the substrate W rotate together around the rotation axis Q1. The substrate holding unit 2 rotates the substrate W until the film forming process is completed.

Next, the first gas supply unit 3 supplies the organic metal gas to the substrate W, the second gas supply unit 5 supplies the first gas containing nitrogen gas and hydrogen gas to the plasma generation unit 4, and the plasma generation unit 4 excites the first gas for plasma (Step S5: first film forming step). A more specific example of the operation will be described below.

First, the control unit 9 opens the valve 512 and the valve 522 of the second gas supply unit 5. As a result, the first gas containing nitrogen gas and hydrogen gas is supplied to the plasma generation unit 4 through the common tube 50, passes through the plasma generation unit 4, and flows inside the chamber 1 toward the substrate W.

Then, the control unit 9 causes the plasma power source 43 to output a high frequency voltage. As a result, an electric field for plasma is generated in the space between the electrode 411 and the electrode 412. When the first gas passes through the electric field, at least a portion thereof turns into plasma. By turning the first gas into plasma, nitrogen radicals and hydrogen radicals are generated, and the excited gas containing these active species flows out of the plasma chamber 4a and flows inside the chamber 1 toward the upper surface of the substrate W.

Next, the control unit 9 opens the valve 33 of the first gas supply unit 3. For example, after the plasma power source 43 outputs a voltage, the control unit 9 opens the valve 33 when the plasma generated by the plasma generation unit 4 is stabilized. As a result, the organic metal gas is supplied into the chamber 1 from the organic metal gas supply source 35 through the supply tube 32 and the discharge nozzle 31, and flows toward the upper surface of the substrate W. The organic metal gas here is TMGa, TEGa or TDMAGa.

The organic metal gas is thermally decomposed on the upper surface of the substrate W, and the group III element (here, gallium) generated by the thermal decomposition reacts with nitrogen radicals, so that a group III-nitride semiconductor film (here, a gallium nitride film) is formed on the substrate W. In other words, the group III-nitride semiconductor is crystal-grown.

In the first film forming step, a mixed gas in which hydrogen gas is added to group V gas is adopted. This allows, as described below, for the crystalline growth of the group III-nitride semiconductor on the upper surface of a heterogeneous material substrate W (specifically, the surface of an underlying film) with high film thickness uniformity.

In other words, during the initial stages of the first film forming step, highly reducing hydrogen radicals react with the upper surface of the substrate W to form dangling bonds. More specifically, highly reducing hydrogen radicals react with impurities such as carbon and oxygen on the upper surface of the substrate W, removing the impurities from the substrate W, thereby forming dangling bonds on the upper surface of the substrate W. And through nitrogen radicals binding to the dangling bonds, nitrogen atoms react with thermally decomposed III-group element while being uniformly arranged on the upper surface of the substrate W, the crystalline growth of the group III-nitride semiconductor takes place on the upper surface of substrate W. Accordingly, the group III-nitride semiconductor can be crystal-grown with high film thickness uniformity on the upper surface of the substrate W. In other words, in the first film forming step, a group III-nitride semiconductor film having a flat upper surface can be formed.

On the other hand, hydrogen radicals react with the organic metal gas as well to generate methane. This methane is prone to be incorporated into the group III-nitride semiconductor; therefore, the carbon content in the semiconductor film increases.

That is, in the first film forming step, the group III-nitride semiconductor film having a high carbon content can be formed with a uniform thickness.

In the first film forming step, after forming the group III-nitride semiconductor film with a predetermined first film thickness, the second gas supply unit 5 supplies the second gas, which does not contain hydrogen and contains nitrogen gas, to the plasma generation unit 4. (Step S6: second film forming step). Specifically, the control unit 9 closes the valve 522 of the hydrogen gas supply unit 52. Thereby, the second gas supply unit 5 stops supplying hydrogen gas. The plasma generation unit 4 excites the second gas that does not contain hydrogen but contains nitrogen gas into plasma, hydrogen radicals are not substantially generated, but nitrogen radicals are generated. The nitrogen radicals are supplied to the substrate W.

Also in the second film forming step, the first gas supply unit 3 supplies the same organic metal gas containing the group III element (here, gallium) as in the first film forming step. The organic metal gas is thermally decomposed on the upper surface of the substrate W, and the group III element generated by the thermal decomposition reacts with nitrogen radicals. Accordingly, the homogeneous group III-nitride semiconductor, similar to the group III-nitride semiconductor in the first film forming step, is crystal-grown.

Hydrogen gas is not supplied to the plasma generation unit 4 in the second film forming step; therefore, the amount of methane generated in the second film forming step is reduced. Therefore, in the second film forming step, the group III-nitride semiconductor film with a lower carbon content is formed.

In addition, in the second film forming step, the homogeneous group III-nitride semiconductor is crystal-grown on the flat group III-nitride semiconductor film formed in the first film forming step; therefore, the group III-nitride semiconductor film with a more uniform thickness can be formed.

In the second film forming step, when the Group III-nitride semiconductor film is formed with a predetermined second film thickness, the control unit 9 ends the second film forming step. Specifically, the control unit 9 closes the valve 33 of the first gas supply unit 3 and the valve 512 of the nitrogen gas supply unit 51, and causes the plasma power source 43 to stop outputting voltage. Further, the control unit 9 stops the operation of the rotation mechanism 23, the heater 7, and the suction unit 6.

Next, the transport device carries out the substrate W from the chamber 1 (Step S7: carrying out process). Specifically, the transport device carries the substrate W placed on the susceptor 21 out of the chamber 1.

As described above, according to the manufacturing apparatus 100, in the first film forming step, the group V gas to be turned into plasma contains hydrogen gas and nitrogen gas. Therefore, as described above, even on the upper surface of the substrate W of a heterogeneous material (the upper surface of the underlying film), the group III-nitride semiconductor film can be formed more flatly. However, the group III-nitride semiconductor film formed in the first film forming step has a large carbon content.

On the other hand, in the second film forming step, the group V gas to be turned into plasma does not contain hydrogen but contains nitrogen gas. Therefore, in the second film forming step, the amount of methane generated can be reduced. In other words, since the amount of methane that is prone to be incorporated into the semiconductor film can be reduced, the group III-nitride semiconductor film with a small carbon content can be formed.

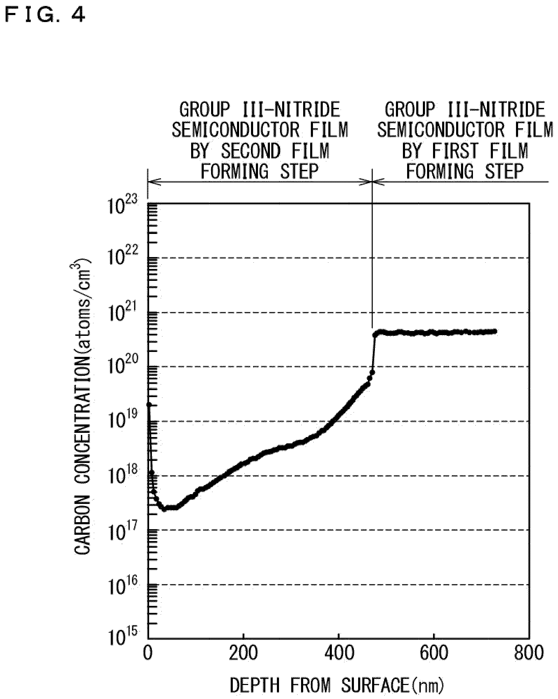

FIG. 4 is a graph illustrating an example of experimental results, and illustrates the carbon concentration distribution in the group III-nitride semiconductor film obtained by secondary ion mass Spectrometry. The horizontal axis indicates the depth from the surface of the group III-nitride semiconductor film, and zero indicates the surface of the semiconductor film. The vertical axis indicates the concentration of carbon in the group III-nitride semiconductor film. Here, experiments were conducted under the following processing conditions. Namely, in the first film forming step, the pressure in the chamber 1 was set to 400 Pa, the flow rate of hydrogen gas was set to 100 sccm, the flow rate of nitrogen gas was set to 1900 sccm, the output power of the plasma power source 43 was set to 1000 W, and the organic metal gas flow rate was set to 6 µmol/minute. In the second film forming step, the pressure in the chamber 1 was set to 400 Pa, the flow rate of nitrogen gas was set to 2000 sccm, the output power of the plasma power source 43 was set to 1000 W, and the flow rate of the organic metal gas was set to 6 µmol/minute.

As can be understood from FIG. 4, the carbon content in the semiconductor film formed in the second film forming step is more than one order of magnitude smaller than the carbon content in the semiconductor film formed in the first film forming step. Therefore, it can be seen that the group III-nitride semiconductor film with high bulk mobility can be formed by the second film forming step. In this manner, the carbon content can be reduced which raises bulk mobility, thereby improving the quality of the film.

Furthermore, in the second film forming step, the homogeneous group III-nitride semiconductor film is formed on the flat group III-nitride semiconductor film formed in the first film forming step. In other words, in the second film forming step, the group III-nitride semiconductor film having a flat upper surface can be formed. In other words, surface morphology can be improved.

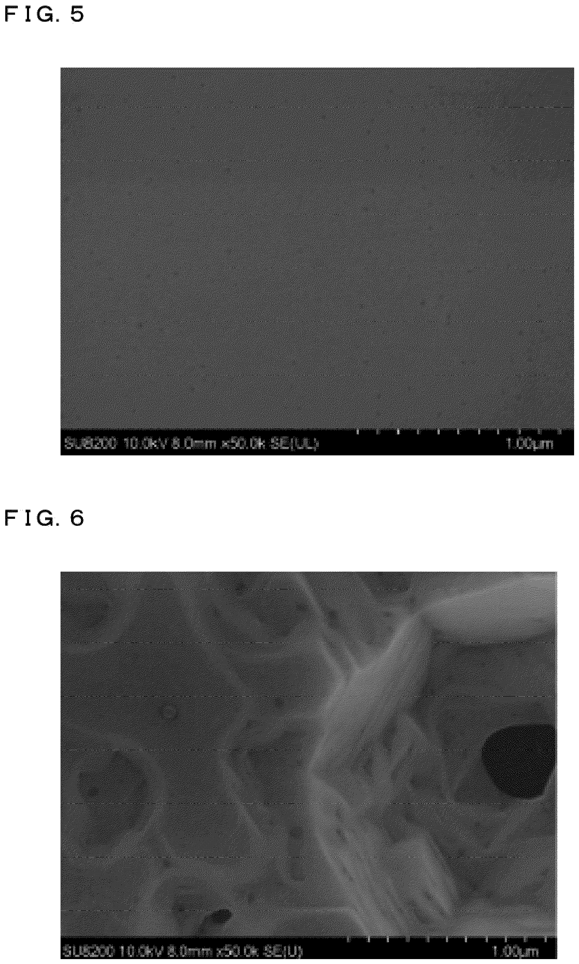

FIG. 5 is a graph illustrating an example of the experimental results, and illustrates an image of the surface (upper surface) of the group III-nitride semiconductor film obtained by a scanning electron microscope. FIG. 6 is a diagram illustrating an image of the front surface of a group III-nitride semiconductor film according to a comparative example. In the comparative example, the group III-nitride semiconductor film was formed on the upper surface of the substrate W in the second film forming step without performing the first film forming step. That is, the second gas, which does not contain hydrogen but contains nitrogen gas, was adopted as the Group V gas. A comparison between FIG. 5 and FIG. 6 illustrates that surface morphology can be improved by performing the first film forming step.

As described above, according to the manufacturing apparatus 100 according to Embodiment 1, the group III-nitride semiconductor film having a low carbon content and good surface morphology can be formed.

Further, in the above-described specific example, the second film forming step (Step S6) is performed consecutively to the first film forming step (Step S5). In other words, simply by stopping the supply of hydrogen gas, the manufacturing step can be shifted from the first film forming step to the second film forming step. According to this, the group III nitride semiconductor film can be formed on the substrate W with high throughput.

### <Flow Rate of Group V Gas>

The second gas supply unit 5 may supply the group V gas to the plasma generation unit 4 in the second film forming step at the same flow rate as the flow rate of the group V gas in the first film forming step. In other words, the flow rate of nitrogen gas in the second film forming step may be set equal to the total flow rate of hydrogen gas and nitrogen gas in the first film forming step.

For comparison, a case will be described in which the flow rate of nitrogen gas is set to be the same in the first film forming step and the second film forming step. In this case, at the time of shifting from the first film forming step to the second film forming step, the flow rate of the group V gas decreases by the amount of the flow rate of hydrogen gas. Although the suction unit 6 regulates the exhaust flow rate to absorb this decrease and regulates the pressure within the chamber 1, the pressure within the chamber 1 may fluctuate transiently. On the other hand, the flow rate of the group V gas being the same in the first film forming step and the second film forming step allows to suppress pressure fluctuations in the chamber 1 suppressed.

Also, when the suction mechanism 62 is connected to other equipment, fluctuations in the exhaust flow rate of gas from the chamber 1 may cause pressure fluctuations in other equipment, however such pressure fluctuations can also be suppressed.

### <Substrate Temperature>

The heater 7 may adjust the temperature of the substrate W to the same value in the first film forming step and the second film forming step. That is, the heater 7 may adjust the temperature of the substrate W to be constant in the first film forming step and the second film forming step. Note that "temperature being constant" includes cases where the temperature fluctuates by several degrees or less.

For comparison, a case will be considered in which the heater 7 sets different temperatures in the first film forming step and the second film forming step. The temperature changes with low responsiveness, thus requiring a relatively long time for the temperature of the substrate W to change. In particular, it requires a longer time when the heater 7 is located apart from the susceptor 21 and the susceptor 21 and the substrate W are heated by thermal radiation. Therefore, the heater 7 changing the temperature of the substrate W during processing brings a decrease in the throughput.

On the other hand, when the heater 7 adjusts the temperature of the substrate W to be constant in the first film forming step and the second film forming step, the above-described decrease in throughput can be avoided.

### <Embodiment 2>

Embodiment 2 intends to further reduce the carbon content in the group III-nitride semiconductor film formed in the second film forming step.

The manufacturing apparatus 100 according to Embodiment 2 has the same configuration as the manufacturing apparatus 100 according to Embodiment 1. However, the operation of the manufacturing apparatus 100 according to Embodiment 2 is different from that of Embodiment 1.

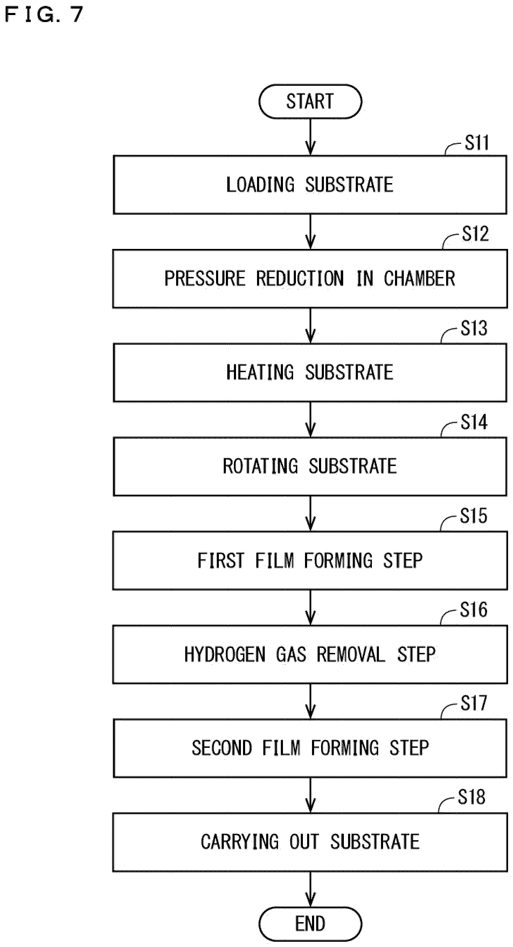

FIG. 7 is a flowchart illustrating an example of the operation of the manufacturing apparatus 100 according to Embodiment 2. Steps S11 to S15 are the same as Steps S1 to S5, respectively.

In Embodiment 2, after Step S15, the hydrogen gas in the chamber 1 is exhausted (Step S16: hydrogen gas removal step). Specifically, the first gas supply unit 3 stops supplying the organic metal gas, the second gas supply unit 5 stops supplying hydrogen gas, and the plasma generation unit 4 stops operating. That is, the control unit 9 closes the valve 33 of the first gas supply unit 3 and the valve 522 of the hydrogen gas supply unit 52, and causes the plasma power source 43 to stop outputting voltage. As a result, the hydrogen gas in the chamber 1 is pushed out by the nitrogen gas supplied from the second gas supply unit 5 and is exhausted from the chamber 1 by the suction unit 6.

Through this hydrogen gas removal step, the amount of hydrogen gas in the chamber 1 decreases over time. When the hydrogen gas in the chamber 1 is sufficiently exhausted, the control unit 9 ends the hydrogen gas removal step. This hydrogen gas removal step is preferably performed until, for example, the partial pressure of hydrogen gas in the chamber 1 becomes 1×10⁻⁸ Pa or less. As a more specific example, the control unit 9 ends the hydrogen gas removal step after a predetermined discharge time (for example, 5 minutes) sufficient for the partial pressure of hydrogen gas to become 1×10⁻⁸ Pa or less has elapsed from the start of the hydrogen gas removal step.

Next, the control unit 9 starts the second film forming step (Step S17). Specifically, the control unit 9 causes the plasma power source 43 to output a voltage. Then, when the plasma generated by the plasma generation unit 4 is stabilized, the control unit 9 opens the valve 33 of the first gas supply unit 3. Thereby, the second film forming step can be substantially started. In the second film forming step, similarly to Embodiment 1, the flat Group III-nitride semiconductor film with a low carbon content can be formed.

In the second film forming step, after forming the group III-nitride semiconductor film with a predetermined second film thickness, the control unit 9 ends the second film forming step. Next, the substrate W is carried out from the chamber 1 (Step S18).

As described above, in Embodiment 2, the hydrogen gas removal step (Step S16) is performed between the first film forming step (Step S15) and the second film forming step (Step S17). Therefore, the second film forming step can be started with the hydrogen gas in the chamber 1 sufficiently exhausted.

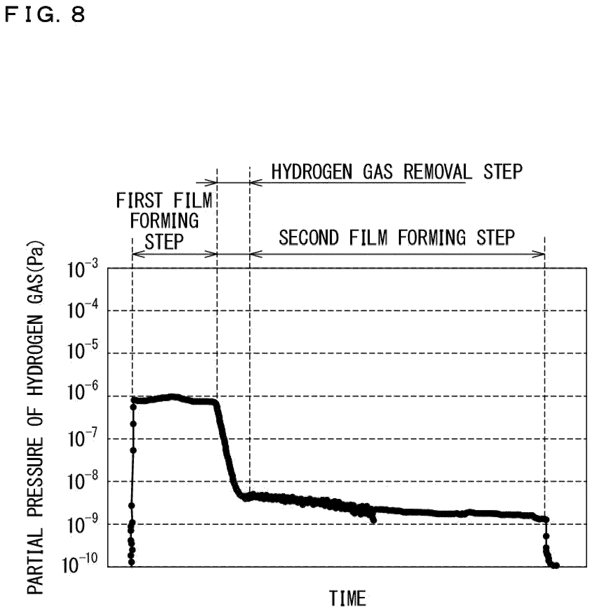

FIG. 8 is a graph illustrating an example of a temporal change in the partial pressure of hydrogen gas inside the chamber 1. As illustrated in FIG. 8, although the partial pressure of hydrogen gas is relatively high during the first film forming step, it decreases over time during the hydrogen gas removal step and ends up being very low during the second film forming step. In the example of FIG. 8, the partial pressure of hydrogen gas during the second film forming step is lower than 1×10⁻⁸ Pa, which is about two orders of magnitude lower than the partial pressure of hydrogen gas during the first film forming step.
the amount of hydrogen gas in chamber 1 is very small in the second film forming step; therefore, reaction between the organic metal gas and hydrogen does not occur much. In other words, according to Embodiment 2, the amount of methane generated in the second film forming step can be further reduced. Therefore, the carbon content in the group III-nitride semiconductor film formed in the second film forming step can be further reduced.

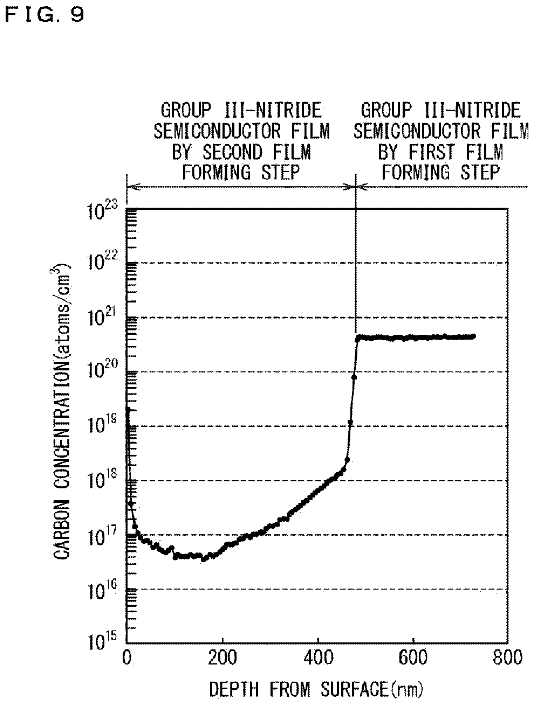

FIG. 9 illustrates the carbon content distribution in the group III-nitride semiconductor film formed by the manufacturing apparatus 100 according to Embodiment 2. As can be understood from the comparison between FIG. 4 and FIG. 9, the carbon content in the semiconductor film formed in the second film forming step can be reduced compared to Embodiment 1. In other words, bulk mobility and film quality can be further improved.

### <Flow Rate of Group V Gas>

The flow rate of the group V gas in the hydrogen gas removal step may be set to be the same as the flow rate of the group V gas in the first film forming step. That is, the second gas supply unit 5 may supply nitrogen gas in the hydrogen gas removal step at the same flow rate as the flow rate of the group V gas in the first film forming step. According to this, suppression of pressure fluctuations and fluctuations in the exhaust flow rate in the chamber 1 at the time of shifting from the first film forming step to the hydrogen gas removal step is enabled.

Also the flow rate of the group V gas in the second film forming step may be set to be the same as the flow rate of the group V gas in the hydrogen gas removal step. According to this, suppression of pressure fluctuations and fluctuations in the exhaust flow rate in the chamber 1 at the time of shifting from the hydrogen gas removal step to the second film forming step is enabled.

### <Embodiment 3>

In Embodiment 3, an example of the operation when ending the second film forming step will be described. The manufacturing apparatus 100 according to Embodiment 3 has the same configuration as the manufacturing apparatus 100 according to Embodiments 1 and 2.

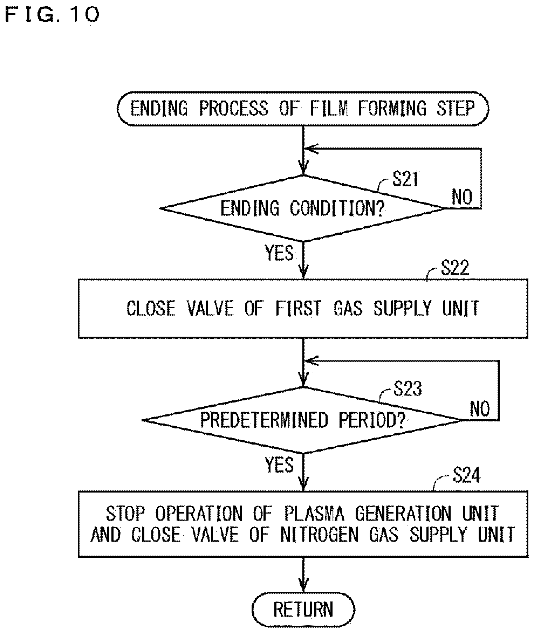

FIG. 10 is a flowchart illustrating an example of the operation of the manufacturing apparatus 100 when ending the second film forming according to Embodiment 2. The control unit 9 determines whether the conditions for ending the second film forming step are satisfied (Step S21). For example, when a predetermined processing time has elapsed since the start of the second film forming step, the control unit 9 determines that the ending condition is satisfied. When the ending condition is not satisfied, the control unit 9 executes Step S21 again.

When the ending condition is satisfied, the control unit 9 closes the valve 33 of the first gas supply unit 32. However, even when the valve 33 is closed, the discharge of the organic metal gas does not stop immediately, and the organic metal gas continues to be discharged from the discharge ports 31a of the discharge nozzle 31. This is because the pressure inside chamber 1 is low. In other words, due to the pressure difference between the pressure within the discharge nozzle 31 and the pressure within the chamber 1, the organic metal gas remaining within the discharge nozzle 31 continues to be discharged into the chamber 1 from the discharge ports 31a. Then, the discharge of the organometallic gas stops in due course.

In Embodiment 3, the supply of nitrogen gas by the second gas supply unit 5 and the operation of the plasma generation unit 4 are continued for a predetermined period after the valve 33 is closed. That is, the control unit 9 leaves to open the valve 512 of the nitrogen gas supply unit 51 and has the plasma power source 43 continue to output voltage. The predetermined period here represents, for example, a sufficient time required from the point when the valve 33 is closed until the discharge of the organic metal gas stops. During this predetermined period as well, the organic metal gas discharged from the discharge nozzle 31 is thermally decomposed on the substrate W, and the group III element generated by the thermal decomposition reacts with nitrogen radicals, resulting in crystal growth of the group III-nitride semiconductor.

The control unit 9 determines whether the predetermined period has passed since the valve 33 is closed (Step S23). When the ending condition is not satisfied, the control unit 9 executes Step S23 again. When the predetermined period has elapsed, the control unit 9 causes the plasma power source 43 to stop outputting voltage, and closes the valve 512 of the nitrogen gas supply unit 51 (Step S24). As a result, the operation of the plasma generation unit 4 and the supply of nitrogen gas by the second gas supply unit 5 are stopped, substantially ending the second film forming step.

As described above, in Embodiment 3, the control unit 9 stops the supply of nitrogen gas and the operation of the plasma generation unit 4 after the predetermined period has passed after the valve 33 of the first gas supply unit 3 is closed, then, ends the second film forming step. Therefore, the group III-nitride semiconductor film is crystal-grown during the predetermined period as well.

For comparison, a case will be described in which the closing of both valve 33 and valve 512, as well as the operation stop of the plasma generation unit 4, are performed simultaneously. While the organic metal gas continues to be discharged from the discharge nozzle 31 even after the valve 33 is closed, the nitrogen radicals in the chamber 1 are quickly dissipated when the plasma generation unit 4 stops operating. Therefore, the organic metal gas is thermally decomposed on the substrate W and reacts with the substrate W without reaction with nitrogen radicals. In other words, the group III element can react with the group III-nitride semiconductor film without reaction with nitrogen radicals. This potentially deteriorates the surface condition of the group III-nitride semiconductor film.

In contrast, in Embodiment 3, nitrogen radicals are supplied to the substrate W at the predetermined period after the valve 33 is closed. Therefore, during the predetermined period as well, the organic metal gas reacts with nitrogen radicals to form the group III-nitride semiconductor on the substrate W. Therefore, deterioration of the surface condition of the semiconductor film can be suppressed or avoided.

Note that in Embodiment 3, the ending operation of the second film forming step has been described and the ending operation may also be applied to the first film forming step in Embodiment 2. Specifically, the plasma generation unit 4 may stop operating after the predetermined period has elapsed since the valve 33 of the first gas supply unit 3 is closed. Therefore, deterioration of the surface condition of the group III-nitride semiconductor film formed in the first film forming step can be suppressed or avoided.

As described above, the manufacturing apparatus 100 and the manufacturing method of the group III-nitride semiconductor have been described in detail, and the above description is illustrative in all aspects, and this manufacturing apparatus 100 and manufacturing method are not limited thereto. It is understood that numerous other modifications can be devised without departing from the scope of the disclosure. The configuration described in each of the above Embodiments and modified examples can be appropriately combined or omitted as long as they do not contradict each other.

### EXPLANATION OF REFERENCE SIGNS

- 1: chamber
- 3: first gas supply unit
- 33: valve
- 4: plasma generation unit
- 5: second gas supply unit
- 6: suction unit
- 7: heater
- S1, S11: loading step (step)
- S2, S12: pressure reduction step (step)
- S3, S13: heating step (step)
- S5, S15: first film forming step (step)
- S6, S17: first film forming step (step)
- S16: hydrogen gas removal step (step)
- W: substrate

## Claims

1. A method of manufacturing a group III-nitride semiconductor comprising:
a loading step in which a substrate is loaded into a chamber;
a pressure reduction step in which a suction unit reduces a pressure in the chamber;
a heating step in which a heater provided in the chamber heats the substrate;
a first film forming step in which a first gas supply unit supplies an organic metal gas containing a group III element to the substrate in the chamber, a second gas supply unit supplies a first gas containing hydrogen gas and nitrogen gas to a plasma generation unit, and the plasma generation unit excites the first gas into plasma and supplies the first gas to the substrate in the chamber; and
a second film forming step in which the first gas supply unit supplies an organic metal gas containing the group III element to the substrate in the chamber, the second gas supply unit supplies a second gas not containing hydrogen and containing nitrogen gas to the plasma generation unit, and the plasma generation unit excites the second gas into plasma and supplies the second gas to the substrate in the chamber.

2. The method of manufacturing the group III-nitride semiconductor according to claim 1, further comprising
a hydrogen gas removal step in which the hydrogen gas is exhausted from the chamber between the first film forming step and the second film forming step.

3. The method of manufacturing the group III-nitride semiconductor according to claim 2, wherein
the hydrogen gas removal step is performed until a partial pressure of hydrogen gas in the chamber becomes 1×10⁻⁸ Pa or less.

4. The method of manufacturing the group III-nitride semiconductor according to claim 1, wherein
the second film forming step is performed consecutively to the first film forming step.

5. The method of manufacturing the group III-nitride semiconductor according to any one of claims 1 to 4, wherein
in the second film forming step, after a predetermined period has elapsed since closing a valve of the first gas supply unit for switching between supply and stop of the organic metal gas, supply of the second gas by the second gas supply unit and operation of the plasma generation unit are stopped to end the second film forming step.

6. The method of manufacturing the group III-nitride semiconductor according to any one of claims 1 to 5, wherein
in the heating step, heating is performed to bring a temperature of the substrate to 600°C or more and 1000°C or less.

7. The method of manufacturing the group III-nitride semiconductor according to any one of claims 1 to 6, wherein
the organic metal gas includes trimethyl gallium, triethyl gallium, or tris dimethylamide gallium.
